# FASCICULE DE BREVET EUROPEEN

(11) **EP 2 304 788 B1**
(45) Date de publication et mention de la délivrance du brevet: **04.07.2012**
(21) Numéro de dépôt: 09802507.5
(22) Date de dépôt: 28.07.2009
(51) Int. Cl.: H01L 21/762

(54) **SUBSTRAT DE TYPE SEMI-CONDUCTEUR SUR ISOLANT A COUCHES DE DIAMANT INTRINSEQUE ET DOPE**
MIT INTRINSISCHEN UND DOTIERTEN DIAMANTFILMEN BESCHICHTETES HALBLEITERSUBSTRAT AUF EINEM ISOLATOR
SEMICONDUCTOR-ON-INSULATOR SUBSTRATE COATED WITH INTRINSIC AND DOPED DIAMOND FILMS

(30) Priorité: 29.07.2008 FR 0855207
(43) Date de publication de la demande: 06.04.2011
(73) Titulaire: Commissariat à l'Énergie Atomique et aux Énergies Alternatives, 75015 Paris (FR)
(72) Inventeur: MAZELLIER, Jean-Paul, 51100 Reims (FR); ANDRIEU, François, F-38000 Grenoble (FR); BERGONZO, Philippe, F-91300 Massy (FR); SAADA, Samuel, F-92340 Bourg La Reine (FR)
(74) Mandataire: Ilgart, Jean-Christophe
(86) Numéro de dépôt international: PCT/EP2009/059762
(87) Numéro de publication internationale: WO 2010/012739

(56) Documents cités:
- WO-A-01/54204
- WO-A-99/62122
- GB-A- 2 253 943
- US-A- 5 317 302
- US-A- 5 682 063
- US-A- 5 777 372
- US-A- 5 943 555
- US-A1- 2003 201 492
- US-A1- 2006 175 293

## Description

### DOMAINE TECHNIQUE

L'invention concerne un substrat de type semi-conducteur sur isolant à couches de diamant intrinsèque et diamant dopé, ainsi qu'un procédé de réalisation d'un tel substrat. L'invention concerne également un circuit électronique comportant un tel substrat, ainsi qu'un procédé de réalisation de ce circuit.

### ÉTAT DE LA TECHNIQUE ANTÉRIEURE

En technologie Bulk, les zones actives des dispositifs CMOS ne sont pas isolées électriquement du substrat, ce qui entraîne la présence de courants de fuite depuis ces zones actives vers le substrat. De plus, les capacités parasites présentes au niveau des jonctions source-substrat et drain-substrat peuvent être importantes et limiter la fréquence de fonctionnement de ces dispositifs. En revanche, la technologie Bulk permet une bonne évacuation de la chaleur depuis les dispositifs semi-conducteurs vers le substrat qui a une forte conductivité thermique (égale à environ 150 W/m/K pour un substrat de silicium).

La technologie SOI (silicium sur isolant) ou plus généralement semi-conducteur sur isolant, de par la présence d'une couche diélectrique enterrée (appelée BOX, et généralement à base de SiO₂ entre une couche massive ou épaisse de semi-conducteur et une couche active de semi-conducteur (par exemple du silicium), permet d'obtenir un meilleur contrôle électrostatique et une réduction des capacités parasites dans des dispositifs semi-conducteurs, par exemple des transistors CMOS (semi-conducteur à oxyde de métal complémentaire), réalisés sur de tels substrats, par rapport à des dispositifs semi-conducteurs similaires réalisés sur un substrat massif de semi-conducteur (technologie Bulk).

Pour la réalisation de transistors dits complètement désertés (« Fully Depleted » ou FDSOI), c'est-à-dire des transistors dont les canaux sont formés dans une couche active de silicium peu dopée (avantageusement de 10¹⁵ cm⁻³, mais pouvant être plus élevé) et dont l'épaisseur est inférieure à 100 nm, l'utilisation de substrats SOI pose également des problèmes. En effet, des phénomènes de « fringing-fields » (couplages électriques source-interface arrière et drain-interface arrière à travers le BOX) apparaissent en technologie SOI. La couche active de silicium se comporte comme une capacité : l'interface arrière de la couche active avec le BOX et l'interface avant de la couche active avec l'isolant de grille du transistor sont donc couplées par électrostatique, le potentiel de la face arrière de la couche active pouvant donc modifier le potentiel de la face avant de la couche active. Seule la présence d'un contact électrique supplémentaire à l'arrière du BOX peut limiter cet effet (en captant préférentiellement les lignes de champ par rapport à l'interface arrière).

Un BOX épais (ayant par exemple une épaisseur supérieure à environ 100 nm pour un BOX de SiO₂) permet d'obtenir un couplage faible entre la face arrière de la couche active et la couche massive de silicium, mais le couplage source-interface arrière et drain-interface arrière augmente à travers l'effet « fringing-field » renforcé. Un BOX très fin (épaisseur inférieure à environ 50 nm) implique un couplage très fort entre la face arrière de la couche active et la couche massive de silicium, ce qui implique également un couplage fort source-substrat et drain-substrat, limitant alors la fréquence de fonctionnement du transistor. Un compromis est dont réalisé.

De plus, par rapport à la technologie Bulk, une couche de SiO₂ est dans ce cas placée directement sous les dispositifs, formant le BOX. Or le SiO₂ présente une faible conductivité thermique (égale à environ 1,4 W/m/K), ce qui limite l'évacuation de la chaleur vers la couche massive de semi-conducteur.

De manière alternative, et en fonction des applications visées, il est connu d'utiliser des substrats SOD (silicium sur diamant) à la place des substrats SOI classiques à BOX de SiO₂. Dans ces substrats, le BOX est formé par une couche de diamant. Toutefois, les problèmes précédemment exposés pour les substrats SOI, et notamment ceux liés à l'évacuation thermique, se retrouvent également dans ces structures.

Le document US 2003/0201492 A1 décrit un circuit comportant des transistors formés sur un substrat comportant un empilement d'une couche massive de silicium et une couche de diamant dopé ou intrinsèque disposée entre la couche massive de silicium et une couche d'oxyde de silicium. Une couche monocristalline de silicium est disposée sur la couche d'oxyde, formant la couche active des transistors. Ce substrat est obtenu en réalisant un dépôt de diamant sur la couche massive de silicium, puis en formant l'oxyde sur le diamant. Compte tenu de la rugosité du diamant lorsque celui-ci est réalisé à partir de la couche massive de silicium, la présence de la couche d'oxyde est nécessaire pour offrir une surface plane permettant le collage de la couche monocristalline de silicium. Le substrat ainsi obtenu a notamment pour inconvénient :
- que la couche d'oxyde a nécessairement une épaisseur irrégulière compte tenu de la rugosité présentée par le diamant, ce qui créé des différences de comportement entre deux transistors réalisés l'un à côté de l'autre sur un tel substrat ;
- l'épaisseur importante du diélectrique occulte les avantages de la couche de diamant en tant que dissipateur thermique ;
- l'interface de collage entre la couche d'oxyde et la couche monocristalline est très proche des transistors, ce qui peut engendrer des défauts d'interface et dégrader le fonctionnement des transistors.

Le document US 5 682 063 A décrit un procédé de réalisation d'un substrat semi-conducteur, comportant les étapes de :
- croissance d'une couche à base de diamant intrinsèque sur une couche à base d'un semi-conducteur;
- dépôt d'une seconde couche à base de diamant d'épaisseur égale à 100 µm sur la couche à base de diamant intrinsèque;
- dopage de la seconde couche à base de diamant.

le document US 5 317 302 A décrit un thermistor et son procédé de fabrication, le thermistor comprenant:
- une couche de diamant dopé d'épaisseur comprise entre 0.5 et 5 µm;
- un empilement de couches comprenant une couche massive de silicium cristallin;
- une couche à base de diamant intrinsèque disposée contre la couche de diamant dopé, entre la couche à base de diamant dopé et la couche massive de silicium cristallin;
   l'empilement de couches comportant aussi une couche diélectrique à base de nitrure de silicium disposée entre la couche massive de silicium cristallin et la couche à base de diamant intrinsèque.

### EXPOSÉ DE L'INVENTION

Un but de la présente invention est de proposer un substrat présentant les avantages d'un substrat de type semi-conducteur sur isolant par rapport à un substrat massif (bon contrôle électrostatique et faibles capacités parasites dans les dispositifs réalisés sur ce substrat ; limitation des effets de canaux courts) tout en optimisant l'évacuation de la chaleur depuis les dispositifs destinés à être réalisés sur ce substrat. Un but de la présente invention est également de proposer un substrat ne présentant pas les inconvénients des substrats de type semi-conducteur sur isolant, c'est-à-dire permettant d'obtenir un couplage électrique optimal entre la face arrière de la couche active et une couche massive du substrat, notamment pour la réalisation de dispositifs semi-conducteurs totalement désertés, et entre des zones actives des dispositifs semi-conducteurs destinés à être réalisés sur ce substrat et une couche arrière de ce substrat.

Pour cela, la présente invention propose un substrat semi-conducteur tel que défini en revendication 1.

Ce substrat permet, grâce à l'utilisation combinée d'une couche de diamant intrinsèque, formant une couche diélectrique enterrée, et d'une couche de diamant dopé, formant une couche conductrice arrière, de profiter des avantages d'une structure SOI (BOX formé par la couche de diamant intrinsèque) tout en optimisant l'évacuation de la chaleur à travers la couche de diamant dopé et la couche de diamant intrinsèque vers l'extérieur ou vers une éventuelle couche de maintien mécanique sur laquelle peut être disposée la couche de diamant dopé, grâce aux propriétés thermiques du diamant (la conductivité thermique à température ambiante du diamant étant égale à environ 2000 W/m/K).

Lorsque le substrat comporte une couche de diélectrique entre la couche de diamant dopé et la couche de semi-conducteur, cette structure forme également une interface électrique optimale entre la couche active du substrat, formée par la couche à base de semi-conducteur, et la couche de diamant intrinsèque. La couche de diamant intrinsèque assure l'isolation électrique de la couche active de semi-conducteur, et donc des dispositifs destinés à être réalisés sur cette couche active, vis-à-vis de la couche de diamant dopé. L'épaisseur de la couche de diamant intrinsèque, par exemple comprise entre environ 50 nm et 1 µm, permet également d'assurer un couplage optimal entre la face arrière de la couche active de semi-conducteur et la couche de diamant dopé, rendant ainsi le substrat adapté pour la réalisation de dispositifs totalement désertés tels que des transistors.

Enfin, la couche de diamant dopé assure un bon contact électrique à l'arrière de la couche de diamant intrinsèque car cette couche forme un plan de fermeture des lignes de champs qui peuvent être générées par les dispositifs réalisés sur la couche active de semi-conducteur du substrat, empêchant l'apparition de couplages électriques source-substrat et drain-substrat à travers le BOX de diamant intrinsèque.

Ce substrat permet de profiter au maximum de la haute conductivité thermique du diamant en utilisant à la fois une couche de diamant intrinsèque et une couche de diamant dopé qui présente un comportement métallique, c'est-à-dire formant à la fois un répartiteur de chaleur et un contact électrique (proche du ou des composants destinés à être réalisés sur le substrat).

Ce substrat peut être utilisé pour la réalisation de tous types de dispositifs semi-conducteurs, et notamment tous types de transistors pouvant être réalisés sur un substrat SOI tels que des transistors FDSOI ou des transistors double grille.

La couche à base de diamant intrinsèque peut avoir une épaisseur comprise entre environ 50 nm et 1 µm et/ou la couche de diamant dopé peut avoir une épaisseur comprise entre environ 0,1 µm et 700 pm. Selon l'invention, l'épaisseur de la couche de diamant dopé est supérieure ou égale à environ 10 µm, par exemple comprise entre environ 10 µm et 700 µm. Ainsi, la couche à base de diamant dopé peut servir de référence de potentiel pour un dispositif semi-conducteur réalisé sur la couche active à base de semi-conducteur, la couche active du dispositif semi-conducteur pouvant correspondre à la couche à base de semi-conducteur du substrat. Dans ce cas, la couche à base de diamant dopé n'est pas utilisée en tant que couche conductrice de courant du dispositif semi-conducteur.

Le substrat peut comporter en outre une couche de maintien mécanique à base de semi-conducteur et/ou d'un matériau diélectrique et/ou de résine et/ou de métal (par exemple de Ti et/ou Pt et/ou W), selon la compatibilité du matériau avec les procédés utilisés, la couche à base de diamant dopé pouvant être disposée entre la couche à base de diamant intrinsèque et ladite couche de maintien mécanique.

L'empilement de couches comporte en outre une couche diélectrique disposée entre la couche à base de semi-conducteur et la couche à base de diamant intrinsèque. Cette couche permet d'obtenir une interface de qualité électrique maximale entre la couche active à base de semi-conducteur et le BOX formé par la couche à base de diamant intrinsèque en évitant les phénomènes de dégradation des performances électrostatiques, réduisant notamment les effets de canaux courts, sur des dispositifs destinés à être réalisés sur ce substrat.

Cette couche diélectrique peut être déposée de manière conforme sur la couche à base de semi-conducteur.

La couche diélectrique peut avoir une épaisseur comprise entre environ 1 nm et 20 nm et/ou être à base d'au moins un matériau de permittivité inférieure à celle du diamant.

L'invention concerne également un procédé de réalisation d'un substrat semi-conducteur tel que défini en revendication 5.

L'étape c) de dopage de la revendication 5 peut être mise en oeuvre simultanément à l'étape b) de dépôt ou de croissance de la revendication 5, par exemple en introduisant les espèces dopantes dans le plasma lorsque la seconde couche à base de diamant est obtenue par un dépôt CVD.

Le procédé comporte en outre, avant l'étape a) de dépôt ou de croissance de la revendication 5, une étape de réalisation d'au moins une couche diélectrique sur une couche à base d'au moins un semi-conducteur, l'étape a) réalisant le dépôt ou la croissance de la couche à base de diamant intrinsèque sur la couche diélectrique.

Le procédé peut comporter en outre, entre l'étape de réalisation de la couche diélectrique et l'étape a) de dépôt ou de croissance, une étape de réalisation d'au moins une couche de nucléation à base d'au moins un matériau diélectrique (par exemple du SiO₂ et/ou du Si₃N₄) et/ou d'un matériau semi-conducteur (par exemple du Si et/ou du SiC) et/ou d'un matériau métallique (par exemple du Pt et/ou du Ti) sur ladite couche diélectrique, la couche de nucléation pouvant être gravée totalement ou partiellement lors de la mise en oeuvre de l'étape a) dépôt ou de croissance. Toutefois, il est possible que ladite couche diélectrique remplisse également la fonction de couche de nucléation, une couche de nucléation supplémentaire n'étant alors pas nécessaire (par exemple lorsque la couche diélectrique est à base de Si₃N₄, de SiO₂ épais, ...).

L'empilement de couches peut comporter une couche d'arrêt de gravure à base d'un matériau diélectrique ou de semi-conducteur dopé disposée contre la couche à base de semi-conducteur, la couche d'arrêt de gravure pouvant être disposée contre une seconde couche, ou couche massive, à base de semi-conducteur. On obtient ainsi un substrat SOI initial dans une approche BESOI.

Le procédé peut comporter en outre, après l'étape c) de dopage de la revendication 5, une étape de retrait de la seconde couche à base de semi-conducteur et/ou de la couche d'arrêt de gravure.

Dans une variante, le procédé peut comporter en outre, entre les étapes a) et b) de dépôt ou de croissance de la revendication 5, une étape d'implantation ionique dans la couche à base de semi-conducteur, formant une interface de fracture dans la couche à base de semi-conducteur, et après l'étape c) de dopage de la revendication 5, une fracture de la couche à base de semi-conducteur au niveau de l'interface de fracture.

Le procédé peut comporter en outre, après l'étape c) de dopage de la revendication 5, une étape de solidarisation de la seconde couche à base de diamant dopé à une couche de maintien mécanique à base de semi-conducteur et/ou d'un matériau diélectrique et/ou de résine. Cette solidarisation peut par exemple être réalisée par le dépôt du matériau de la couche de maintien sur la seconde couche à base de diamant dopé, formant ainsi la couche de maintien solidarisée à la seconde couche à base de diamant dopé.

Le procédé peut comporter en outre, avant l'étape a) de dépôt ou de croissance de la revendication 5, une étape de dépôt d'une couche sacrificielle à base d'au moins un matériau diélectrique sur la couche à base de semi-conducteur ou sur l'empilement de couches, cette couche sacrificielle pouvant être gravée lors de l'étape a) de dépôt ou de croissance qui est réalisée du côté de la couche sacrificielle.

La présente invention concerne également un circuit électronique comportant au moins un dispositif semi-conducteur réalisé sur la couche à base de semi-conducteur d'un substrat tel que décrit précédemment.

Le circuit électronique peut comporter en outre une couche de connexions réalisée sur la couche à base de semi-conducteur et reliée électriquement au dispositif semi-conducteur.

Enfin, l'invention concerne aussi un procédé de réalisation d'un circuit électronique, comportant au moins les étapes de :
a) réalisation d'une structure comportant au moins d'une couche à base de semi-conducteur dans laquelle est réalisé au moins un dispositif semi-conducteur, disposée sur une seconde couche, ou couche massive, à base de semi-conducteur,
b) solidarisation de la couche à base de semi-conducteur à une couche de maintien mécanique à base de semi-conducteur et/ou d'un matériau diélectrique et/ou de résine,
c) retrait de la seconde couche à base de semi-conducteur,
d) mise en oeuvre d'un procédé de réalisation d'un substrat semi-conducteur tel que décrit précédemment à partir de la structure précédemment réalisée.

En réalisant le substrat comportant les couches de diamant après la mise en oeuvre des étapes a), b) et c) du procédé de réalisation du circuit électronique, on évite d'avoir à encapsuler les couches de diamant pour les protéger des hautes températures (par exemple supérieures à environ 600°C) engendrées lors de la réalisation du ou des dispositifs semi-conducteurs du circuit électronique. Dans cette variante, les dépôts de diamant peuvent être faits à des températures compatibles avec le budget thermique admissible des dispositifs semi-conducteurs réalisés (en ne dépassant pas par exemple une température maximum de l'ordre de 400°C).

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 et 2 représentent des substrats à couches de diamant intrinsèque et dopé, objets de la présente invention, respectivement selon un premier et un seconde mode de réalisation,
- la figure 3 représente des courbes d'évolution du DIBL (abaissement de barrière induit par le drain) d'un transistor MOSFET réalisé sur différents types de substrat,
- la figure 4 représente des courbes d'évolution de la température dans un transistor MOSFET réalisé sur un substrat SOI standard et sur un substrat à couches de diamant intrinsèque et dopé,
- la figure 5 représente une simulation de l'évolution de la température dans un microprocesseur double coeur réalisé à partir d'un substrat à couches de diamant intrinsèque et dopé,
- les figures 6A à 6G représentent les étapes d'un procédé de réalisation d'un substrat, objet de la présente invention, selon le premier mode de réalisation,
- les figures 7A à 7E représentent les étapes d'un procédé de réalisation d'un substrat, objet de la présente invention, selon le second mode de réalisation,
- les figures 8A à 8D représentent les étapes d'un autre procédé de réalisation d'un substrat, objet de la présente invention, selon le second mode de réalisation,
- les figures 9A à 9D représentent les étapes d'un procédé de réalisation d'un substrat, objet de la présente invention, selon un troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

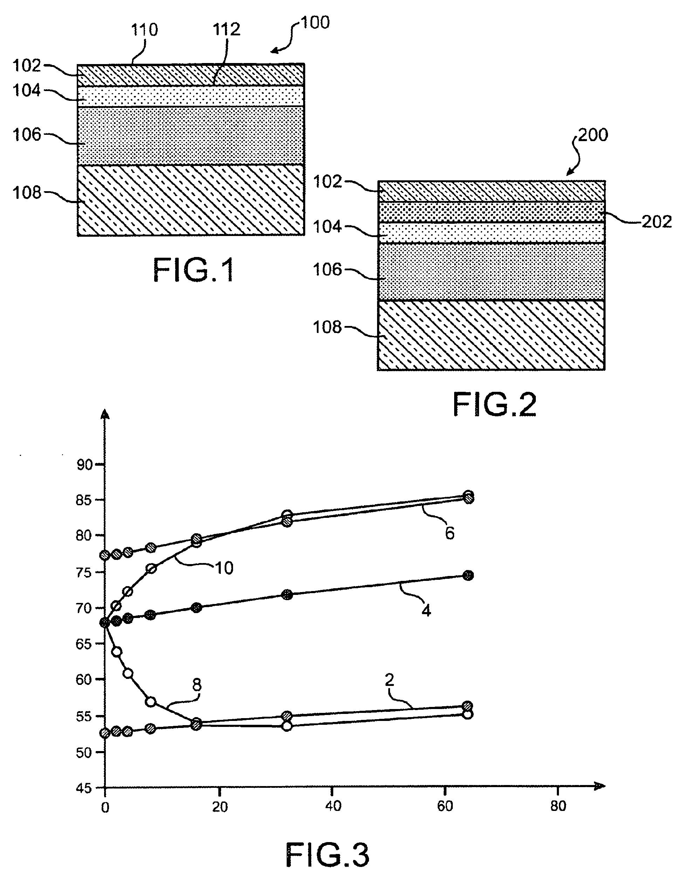

On se réfère tout d'abord à la figure 1 qui représente un substrat semi-conducteur 100 selon un premier exemple.

Le substrat 100 comporte une couche active 102 à base de semi-conducteur, par exemple du silicium et/ou du germanium et/ou de toute combinaison des matériaux de la colonne IV du tableau de classification périodique des éléments (SiC, SiGe, ...), ou encore à base d'un alliage de matériaux des colonnes III (Ga, Al, In) et V (N, P, As, Sb) du tableau de classification périodique des éléments (par exemple : GaAsₓP₁₋ₓ, GaAsₓSb₁₋ₓ, AsInₓGa₁₋ₓ, InGaₓSb₁₋ₓ, PGaₓIn₁₋ₓ, AlAsₓSb₁₋ₓ, AsAlₓIn₁₋ₓ, SbGaₓAl₁₋ₓ, disposée sur une couche diélectrique 104 à base de diamant intrinsèque et une couche électriquement conductrice 106 à base de diamant dopé. Ces trois couches sont disposées sur une couche ou un empilement de couches de maintien mécanique 108, par exemple à base de semi-conducteur tel que du silicium monocristallin ou polycristallin. La couche ou l'empilement de couches de maintien mécanique 108 peut également être à base d'un matériau diélectrique et/ou de résine et/ou de métal (par exemple de Ti et/ou Pt et/ou W), ou plus généralement tout matériau compatible avec les procédés utilisés pour la réalisation du substrat 100.

La couche active 102 a une épaisseur comprise entre environ 5 nm et 1 µm. La couche de diamant intrinsèque 104 a une épaisseur comprise entre environ 50 nm et 1 µm. Le diamant de la couche 104 peut être monocristallin ou polycristallin. Le diamant polycristallin peut être composé de grains colonnaires ou d'un empilement de nanograins (diamant nanocristallin). Un diamant nanocristallin présente moins de rugosité qu'un diamant polycristallin à structure colonnaire. En revanche, un diamant nanocristallin présente plus de joints de grain qu'un diamant polycristallin, ce qui peut réduire sa conductivité thermique.

La couche électriquement conductrice 106 à base de diamant dopé a une épaisseur comprise entre environ 0,1 µm et 700 µm ou entre 20 µm et 500 µm. L'épaisseur de la couche de diamant dopé 106 peut notamment être choisie en fonction de l'application de ce substrat 100 ainsi que d'autres considérations industrielles telles que le coût et la vitesse de croissance du diamant de cette couche 106. Le diamant de la couche 106 est dopé, par exemple avec du Bore ou toute espèce permettant de conférer à la couche 106 de diamant un comportement électriquement conducteur. Lorsque du bore est utilisé pour réaliser le dopage de la couche de diamant 106, on réalise alors un dopage de type N, par exemple égal ou supérieur à environ 10²¹ cm⁻³ afin d'assurer un comportement métallique à la couche de diamant 106. Lorsque la couche 106 est dopée de type N par exemple par du phosphore ou un complexe de bore hydrogéné, ce dopage peut également être égal ou supérieur à environ 10²¹ cm⁻³ afin d'assurer un comportement métallique à la couche de diamant 106. La couche de maintien mécanique 108 peut avoir une épaisseur comprise entre environ 300 µm et 700 µm, en fonction du diamètre du substrat

Dans une variante de ce premier exemple, le substrat 100 peut ne pas comporter la couche de maintien mécanique 108, notamment lorsque les couches de diamant 104 et 106 ont une épaisseur totale supérieure ou égale à environ 500 µm, ou plus généralement une épaisseur permettant d'assurer un maintien mécanique suffisant pour le substrat 100. Dans une autre variante, le substrat 100 peut également comporter une couche tampon disposée entre le substrat mécanique 108 et la couche de diamant 106 permettant d'assurer l'adhérence entre la couche de diamant dopé 106 et la couche de maintien mécanique 108.

La figure 2 représente un substrat 200 selon un mode de réalisation de l'invention. Le substrat 200 comporte les couches 102 à 108 précédemment décrites en liaison avec le substrat 100 représenté sur la figure 1. Par rapport au substrat 100, le substrat 200 comporte une couche diélectrique 202 supplémentaire, par exemple à base de SiO₂ et/ou de SiC, disposée entre la couche active 102 et la couche de diamant intrinsèque 104 et d'épaisseur comprise entre environ 1 nm et 100 nm, et préférentiellement comprise entre environ 1 nm et 20 nm. La couche diélectrique 202 est de préférence réalisée à base d'un matériau de permittivité inférieure à celle du diamant dans le cas de transistor FDSOI.

Ces deux substrats 100 et 200 comportent un diélectrique enterré, ou BOX, formé par la couche de diamant intrinsèque 104 réalisant l'isolation électrique de la couche active 102 vis-à-vis de la couche de diamant dopé 106. D'un point de vue électrique, la présence de cette couche de diamant intrinsèque 104 modifie l'électrostatique d'un dispositif semi-conducteur, par exemple un transistor totalement déserté, réalisé sur l'un de ces substrats 100 et 200 par rapport à un même transistor réalisé sur un substrat SOI classique. En effet, dans ce type de transistor, les couplages entre une face avant (référencée 110 sur la figure 1) et une face arrière (référencée 112 sur la figure 1) de la couche active 102 interviennent au niveau du contrôle électrostatique et des effets de canaux courts du transistor. Par rapport à un BOX à base de SiO₂, un BOX à base de diamant à une permittivité légèrement plus importante (permittivité du diamant = 5,5 ; permittivité du SiO₂ = 3, 9), les impacts sur le DIBL et le courant I_{off} du transistor réalisé sur ce substrat étant faibles. Le diamant présente donc un très bon compromis entre une forte conductivité thermique et une faible permittivité électrique.

La présence de la couche diélectrique 202, qui est ici à base d'un matériau de permittivité inférieure à celle du diamant, permet de réduire les effets de canaux courts sur les transistors réalisés sur ce substrat, évitant les phénomènes de dégradation des performances électrostatiques au niveau de l'interface avec la face arrière du transistor optimale.

La figure 3 représente l'évolution du DIBL pour des transistors de type nMOSFET de longueur de grille égale à environ 25 nm sur une couche de silicium 102 d'épaisseur égale à environ 5 nm, réalisés sur le substrat 200, en fonction de l'épaisseur de la couche diélectrique 202 et de la nature du matériau de la couche 202. Afin de pouvoir comparer ces résultats, les courbes 2, 4 et 6 représentent respectivement l'évolution du DIBL (en mV/V sur l'axe des ordonnées) d'un tel transistor réalisé sur un substrat SOI comportant un BOX à base de SiO₂ (courbe 2), de diamant (courbe 4) ou de BeO (courbe 6), en fonction de l'épaisseur du BOX (en nm sur l'axe des abscisses). Les courbes 8 et 10 représentent l'évolution du DIBL de ce même transistor réalisé sur le substrat 200 comportant une couche de diamant intrinsèque d'épaisseur égale à environ 100 nm et une couche diélectrique 202 à base de SiO₂ (courbe 8) ou de BeO (courbe 10) disposée entre une couche de silicium 102 d'épaisseur égale à environ 5 nm et la couche de diamant intrinsèque, en fonction de l'épaisseur (en nm sur l'axe des abscisses) de cette couche diélectrique 202.

Etant donné que le BeO a une permittivité (égale à environ 6,7) supérieure à celle du diamant (égale à environ 5,7), la courbe 10 montre bien que la présence d'une couche 202 à base d'un matériau de permittivité supérieure à celle du diamant augmente le DIBL d'un transistor réalisé sur un tel substrat 200. Par contre, lorsque cette couche 202 est à base d'un matériau de permittivité inférieure à celle du diamant comme le SiO₂, il est alors possible de réduire ce DIBL et donc de réduire les effets de canaux courts sur ce transistor. De manière générale, cet effet s'observe quelque soit l'épaisseur de la couche de diamant intrinsèque 104 (par exemple comprise entre environ 50 nm et 1 µm) et quelque soit la longueur du canal du transistor (par exemple égale à environ 20 nm, 50 nm ou 100 nm).

La couche diélectrique 202 présente dans le substrat 200 permet donc de réduire notablement les effets de canaux courts, même lorsqu'elle a une faible épaisseur, par exemple égale à environ 10 nm.

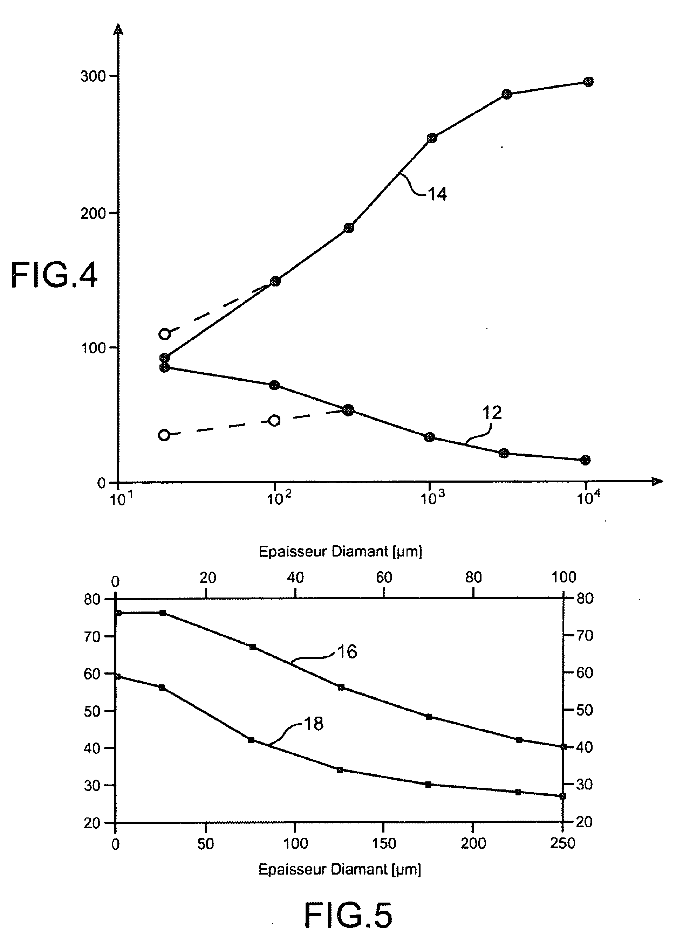

L'utilisation d'un BOX à base de diamant intrinsèque permet d'améliorer la dissipation thermique dans le substrat par rapport à l'utilisation d'un BOX à base de SiO₂. La figure 4 illustre ceci en présentant l'évolution de la température (en Kelvin sur l'axe des ordonnées) au niveau du drain d'un MOSFET dissipant environ 1 mW/µm réalisé sur un substrat SOI comprenant un BOX de SiO₂ (courbe 14) et sur le substrat 100 (courbe 12), c'est-à-dire comportant un BOX de diamant intrinsèque et une couche de diamant dopé, en fonction de l'épaisseur du BOX (en nm sur l'axe des abscisses). Ces deux courbes montrent qu'un BOX à base de diamant intrinsèque permet de réduire l'élévation de chaleur de façon plus efficace qu'une couche d'oxyde enterrée (épaisse ou mince), et cela sans réduire la vitesse de fonctionnement ou de commutation du transistor.

De plus, dans le cas du substrat 200 comportant une couche de diélectrique 202 supplémentaire à base de SiO₂ disposée entre la couche de diamant intrinsèque 104 et la couche active de semi-conducteur 102, la température d'un transistor réalisé sur la couche active 102 est également réduite significativement, notamment lorsque la couche diélectrique 202 a une épaisseur inférieure ou égale à environ 10 nm.

L'empilement formé par la couche de diamant intrinsèque 104 et la couche de diamant dopé 106 ne présente pas de résistance d'interface car les matériaux en contact l'un avec l'autre sont de même nature. Ceci optimise donc la dissipation thermique à travers le substrat.

Cette meilleure dissipation thermique se retrouve également dans les dispositifs réalisés à partir d'un tel substrat. La figure 5 représente une simulation de l'évolution de la température dans un microprocesseur double coeur réalisée avec une carte de génération de chaleur et un environnement réaliste (tel que décrit dans le document « Analytical modeling for prediction of hot spot chip junction temperature for electronics cooling applications » de M. Iyengar et al., IEEE Itherm conference, 2006). Ces simulations sont réalisées pour un substrat de structure similaire au substrat 100 et d'épaisseur totale égale à 100 µm (courbe 16) ou 250 µm (courbe 18), l'évolution de la température (en Kelvin sur l'axe des ordonnées) étant représentée en fonction de l'épaisseur totale de diamant dans le substrat (en µm sur l'axe des abscisses).

Les substrats tendent à être amincis pour que les puces mises en boîtier soient le plus mince possible. Comme représenté sur la figure 5, un substrat d'épaisseur égale à environ 100 µm entraîne une augmentation de température maximum du circuit de 15°K par rapport à un substrat d'épaisseur égale à environ 250 µm (car une épaisseur moindre implique moins d'effet d'étalement de chaleur). Cette augmentation de température peut être annulée en intégrant 40 µm de diamant dans le substrat, augmentant ainsi sa capacité à diriger la chaleur latéralement dans la puce, offrant ainsi une section efficace d'évacuation plus grande.

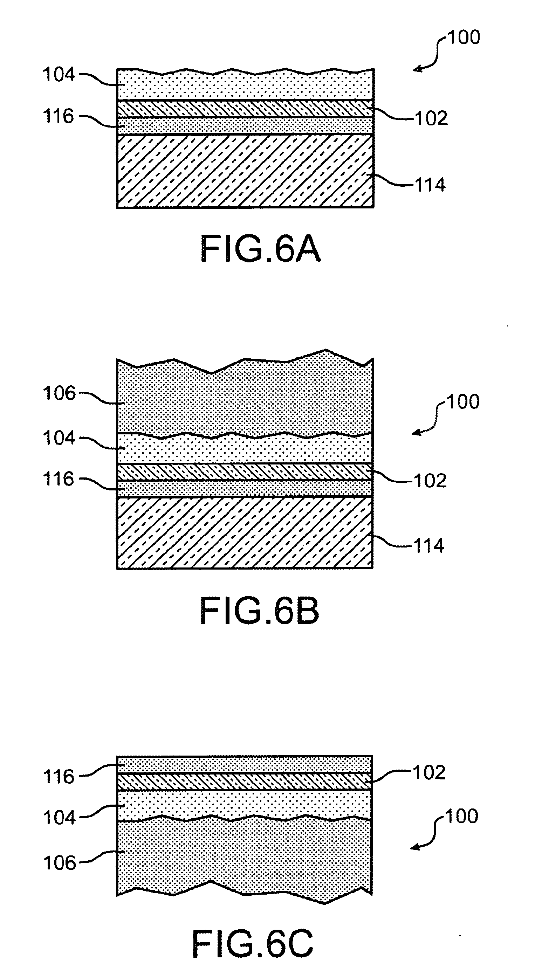

On se réfère maintenant aux figures 6A à 6G qui représentent les étapes d'un procédé de réalisation du substrat 100 selon le premier exemple.

Comme représenté sur la figure 6A, on dépose tout d'abord une couche diélectrique 104 à base de diamant sur une couche active 102 à base de semi-conducteur, par exemple du silicium et/ou germanium et/ou tout autre semi-conducteur. La couche active 102 est la couche supérieure d'un empilement comportant une couche massive 114 à base de semi-conducteur, par exemple du silicium, c'est-à-dire la couche de maintien mécanique d'un substrat SOI initial, sur laquelle est disposée une couche 116 d'arrêt de gravure, la couche active 102 étant disposée sur la couche 116 d'arrêt de gravure. La couche massive 114 a une épaisseur comprise entre environ 300 µm et 700 µm. De manière générale, on appelle couche massive une couche dont l'épaisseur est égale ou supérieure à environ 10 µm. La couche d'arrêt de gravure 116 est par exemple · réalisée à base d'un matériau diélectrique tel que du SiO₂ et/ou du Si₃N₄, et/ou de semi-conducteur fortement dopé, par exemple du silicium, et a une épaisseur comprise entre environ 10 nm et 1 µm. Le dépôt de la couche diélectrique de diamant 104 peut être réalisé par MPCVD (dépôt chimique en phase vapeur assisté par plasma micro-ondes), HFCVD (dépôt chimique en phase vapeur par filament chaud) ou tout autre technique adaptée au dépôt de diamant. La couche de diamant 104 peut également être réalisée par croissance sur la couche active 102.

Sur la figure 6B, une couche de diamant 106 est déposée ou réalisée par croissance sur la couche de diamant intrinsèque 104, et dopée par exemple par un dopage au Bore ou toute autre espèce chimique adaptée pour conférer à la couche de diamant 106 un caractère métallique, c'est-à-dire un comportement électriquement conducteur.

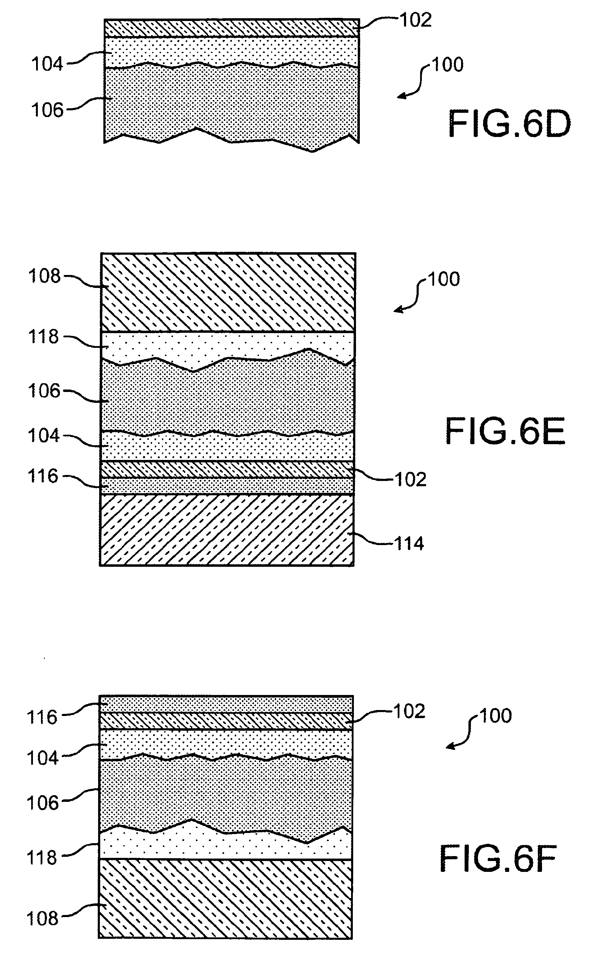

Lorsque les couches de diamant 104 et 106 sont suffisamment épaisses (l'épaisseur totale des couches 104 et 106 étant par exemple supérieure ou égale à environ 500 µm) pour assurer un maintien mécanique suffisant au substrat 100, on retire alors la couche massive 114, par exemple par polissage, meulage, attaque chimique ou toute autre technique adaptée à un tel retrait, comme représenté sur la figure 6C. La couche d'arrêt de gravure 116 est ensuite retirée par l'une des techniques précédemment mentionnées pour le retrait de la couche massive 114 ou toute autre technique adaptée à un tel retrait (figure 6D).

Lorsque les couches de diamant 104 et 106 ne permettent pas d'assurer un maintien mécanique suffisant du substrat 100 (par exemple lorsque l'épaisseur totale des couches 104 et 106 est inférieure à environ 500 µm), la structure précédemment formée (représentée sur la figure 6B) est reportée soit directement par dépôt sur une couche de maintien mécanique 108, soit, comme représenté sur la figure 6E, reportée sur la couche 108 par l'intermédiaire d'une couche tampon 118, notamment lorsque ladite structure est reportée par collage. La couche tampon 118 permet notamment « d'absorber » la rugosité pouvant être présente au niveau de la face de la couche de diamant dopé 106 destinée à être du côté de la couche de maintien mécanique 108.

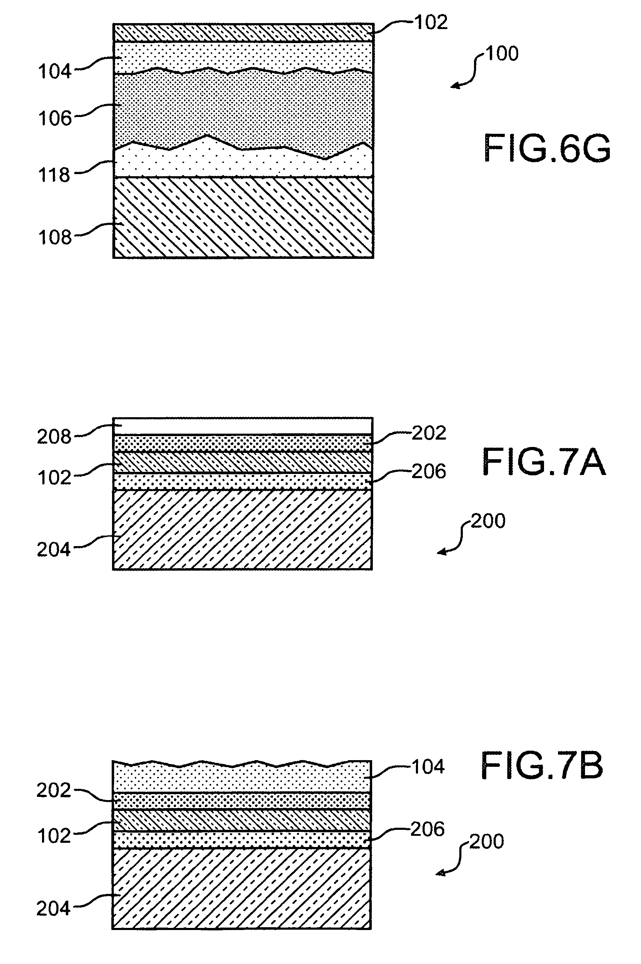

Enfin, comme précédemment décrit en liaison avec les figures 6C et 6D, on retire la couche massive 114 (figure 6F) puis on retire la couche d'arrêt de gravure 116 (figure 6G).

On se réfère maintenant aux figures 7A à 7E qui représentent les étapes d'un procédé de réalisation du substrat 200.

Sur la figure 7A, on dépose une couche diélectrique 202 sur un substrat de type semi-conducteur sur isolant comportant une couche massive 204 à base d'un matériau semi-conducteur tel que du silicium et/ou du germanium, sur lequel sont disposées une couche diélectrique 206 et une couche active 102 de semi-conducteur. La couche diélectrique 202 est ici une couche mince ayant une épaisseur comprise entre environ 1 nm et 20 nm.

Sur l'exemple de la figure 7A, une couche de nucléation 208 à base d'un matériau diélectrique (par exemple du SiO₂ et/ou du Si₃N₄ et/ou du TiO₂), et/ou d'un matériau semi-conducteur (par exemple du Si et/ou du SiC et/ou de Ge) et/ou d'un matériau métallique (par exemple du Pt et/ou du Ti et/ou de l'Ir et/ou du Ni et/ou du Mo et/ou de l'Au et/ou du W) qui servira par la suite de barrière et/ou de précurseur lors de la réalisation de la couche de diamant intrinsèque 104, est déposée sur la couche diélectrique 202. Cette couche de nucléation a par exemple une épaisseur comprise entre environ 1 nm et 100 nm, et de préférence comprise entre environ 5 nm et 50 nm.

Cette couche de nucléation pourra être avantageusement retirée durant l'étape de croissance du diamant, l'objectif étant donc de minimiser voir annuler l'épaisseur de ce matériau durant la croissance du diamant tout en préservant l'intégrité de la couche diélectrique. Afin de calculer l'épaisseur de la couche de nucléation 208, il est possible de réaliser les étapes suivantes :
- à partir d'un substrat de semi-conducteur massif, on dépose la couche diélectrique 202 de l'épaisseur souhaitée puis on dépose une couche du matériau de nucléation d'épaisseur égale à environ 10 nm ;
- on réalise ensuite la croissance du diamant 104 sur la couche de nucléation puis on vérifie l'intégrité de la couche diélectrique 202, par exemple par des mesures de la conductivité électrique et/ou de l'épaisseur résiduelle de la couche diélectrique 202, par rapport à un critère fixé au préalable (par exemple un niveau de conductivité électrique maximum ou une épaisseur résiduelle minimum). Deux cas se présentent alors :
- si cette intégrité est vérifiée, on réalise alors un nouveau dépôt de diamant avec une couche de nucléation 1 nm moins épaisse que précédemment et on vérifie l'intégrité du diélectrique. On procède ainsi jusqu'à ne plus pouvoir assurer l'intégrité fixée.
- si cette intégrité n'est pas vérifiée, on réalise alors un nouveau substrat avec dépôt de la couche diélectrique et dépôt de la couche de nucléation 1 nm plus épais que précédemment et on vérifie l'intégrité après la croissance du diamant. On procède ainsi jusqu'à assurer l'intégrité que l'on s'est fixée.

On obtient ainsi l'épaisseur optimale de la couche de nucléation 208

Comme représenté sur la figure 7B, on réalise la croissance de la couche de diamant 104 sur la structure précédemment réalisée. La croissance du diamant sur certains matériaux, par exemple le SiO₂, peut graver et détériorer ces matériaux, ce qui est préjudiciable pour la réalisation du substrat 200. Compte tenu de la présence de la couche sacrificielle 208, l'intégrité de la couche diélectrique 202 est préservée grâce au rôle sacrificiel de la couche 208. En choisissant une couche 208 d'épaisseur comprise entre environ 1 nm et 10 nm, la croissance de la couche de diamant 104 entraine la suppression totale ou partielle de la couche 208, la couche de diamant intrinsèque 104 se retrouvant formée sur la couche diélectrique 202.

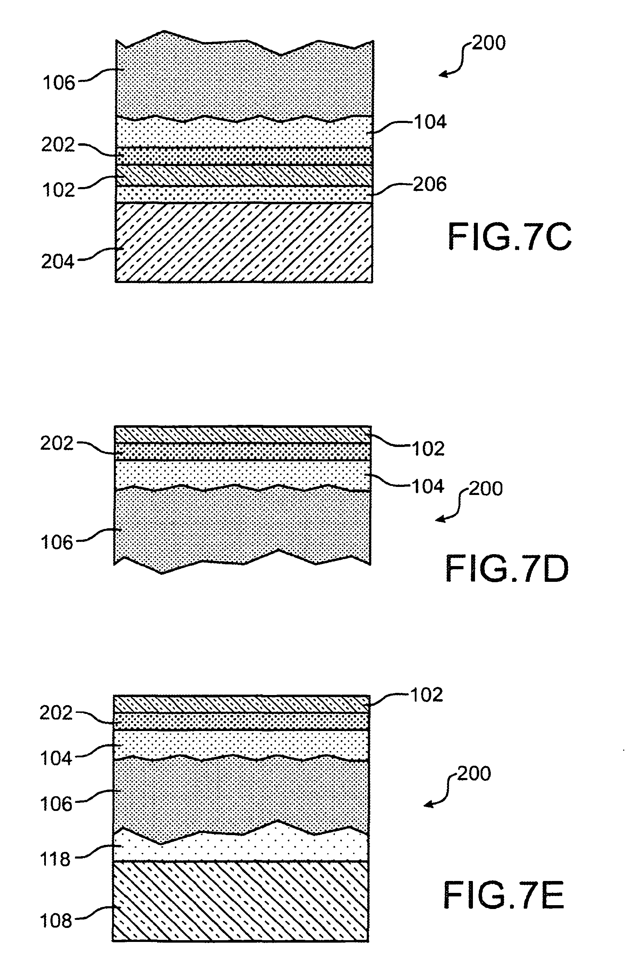

Comme pour la réalisation du substrat 100, on réalise ensuite la croissance ou le dépôt de la couche de diamant 106 sur la couche de diamant intrinsèque 104, et le dopage de cette couche de diamant 106 afin que celle-ci devienne électriquement conductrice (figure 7C).

Le substrat 200 est enfin achevé de manière similaire au substrat 100 en réalisant soit directement le retrait de la couche massive 204 et de la couche diélectrique 206 lorsque les épaisseurs des couches de diamant 104 et 106 sont suffisantes pour assurer un maintien mécanique du substrat 200 (figure 7D), soit de réaliser le report de la structure réalisée sur une couche de maintien mécanique 108 (éventuellement par l'intermédiaire une couche tampon 118) avant de retirer la couche massive 204 et la couche diélectrique 206 (figure 7E).

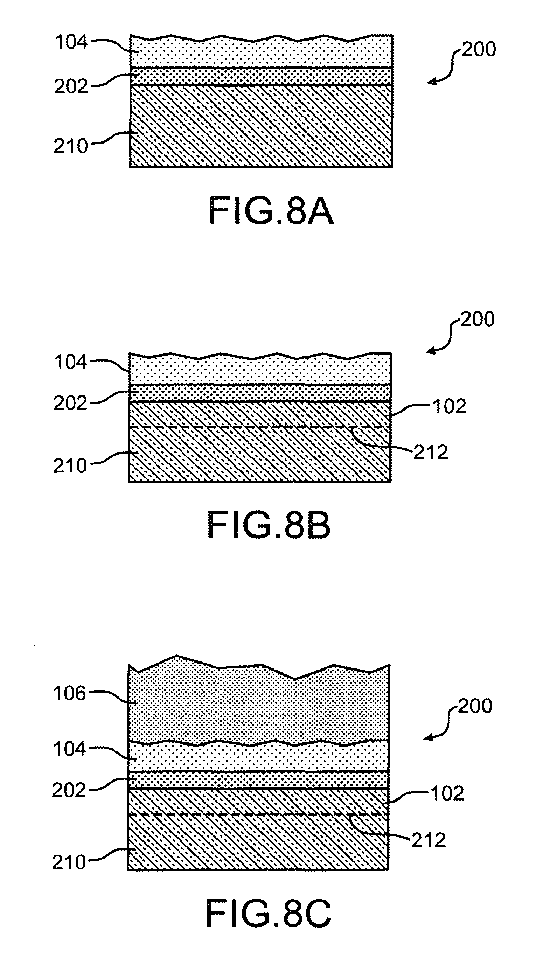

Dans une variante du premier exemple ou du mode de réalisation selon l'invention précédemment décrits, les substrats 100 et 200 peuvent être réalisés non pas à partir d'un substrat de type semi-conducteur sur isolant, comme décrit en liaison avec les figures 6A à 6G et 7A à 7E, mais à partir d'un substrat massif à base de semi-conducteur. Les figures 8A à 8D représentent les étapes d'un tel procédé de réalisation pour le substrat 200.

Sur la figure 8A, on réalise le dépôt ou la croissance d'une couche de diamant intrinsèque 104 sur une couche diélectrique 202 disposée sur un substrat massif 210 à base de semi-conducteur tel que du silicium. Comme dans le procédé précédemment décrit en liaison avec les figures 7A à 7E, la croissance de la couche de diamant 104 peut être réalisée sur une couche d'arrêt préalablement déposée sur la couche diélectrique 202, similaire à la couche 208 précédemment décrite.

On réalise ensuite une implantation ionique dans le substrat massif 210, formant une interface de fracture 212 dans celui-ci (figure 8B). La partie du substrat massif 210 se trouvant entre la couche diélectrique 202 et l'interface de fracture 212 est destinée à former la couche active 102.

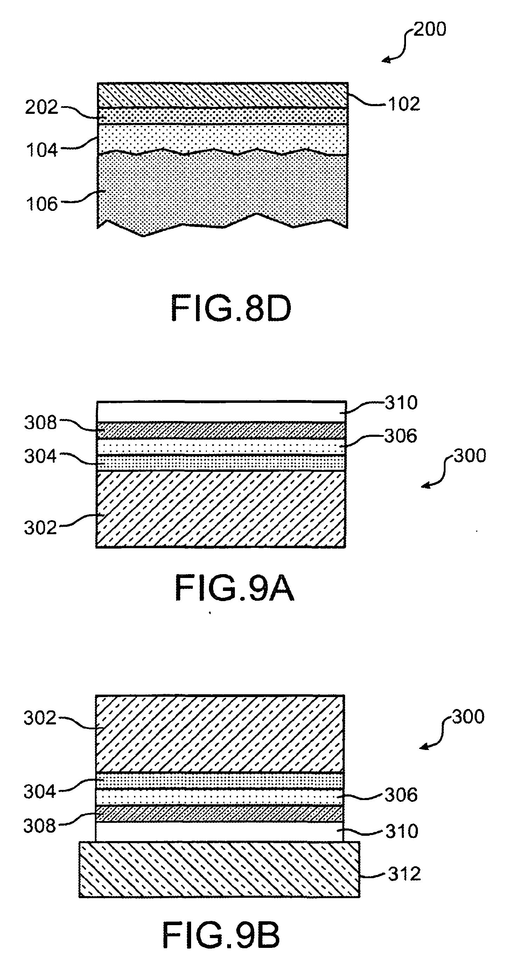

On procède ensuite à la croissance d'une couche de diamant dopé 106 à basse température, c'est-à-dire une température comprise entre environ 200°C et 500°C, ou de préférence comprise entre environ 300°C et 400°C pour améliorer la qualité de la couche de diamant dopé 106, afin d'éviter la fracture du substrat massif 210 au niveau de l'interface 212 (figure 8C). Enfin, on sépare la couche active 102 du reste du substrat 210 par fracture au niveau de l'interface 212 (figure 8D).

Comme dans les procédés précédemment décrits, il est possible, avant de réaliser la séparation de la couche active 102 du reste du substrat massif 210, lorsque les couches de diamant 104 et 106 n'ont pas une épaisseur suffisante pour assurer le maintien mécanique du substrat 200, de reporter cette structure sur une couche de maintien mécanique 108, éventuellement par l'intermédiaire d'une couche tampon 118 entre la couche électriquement conductrice de diamant 106 et la couche de maintien mécanique 108.

De manière analogue au procédé décrit ci-dessus en liaison avec les figures 8A à 8D, il est également possible de réaliser le substrat 100 à partir d'un substrat massif 210. Pour cela, la couche de diamant intrinsèque 104 est directement réalisée sur le substrat massif 210 et non sur une couche diélectrique 202. Les étapes réalisées sont ensuite similaires à celles précédemment décrites en liaison avec les figures 8B à 8D.

Le substrat à couches de diamant intrinsèque et dopé peut servir à la réalisation d'un circuit comportant des composants semi-conducteurs intégrés. Les figures 9A à 9D représentent les étapes d'un procédé de réalisation d'un circuit électronique 300, faisant appel à un substrat à couches de diamant intrinsèque et dopé tels que l'un des substrats 100 et 200 décrits précédemment.

Comme représenté sur la figure 9A, on réalise tout d'abord une structure de type semi-conducteur sur isolant comportant une couche massive 302 à base de semi-conducteur, par exemple du silicium, sur laquelle sont empilées une couche diélectrique 306, par exemple à base de SiO₂ et d'épaisseur comprise entre environ 1 nm et 20 nm, une couche active 308 dans laquelle sont réalisés des composants actifs (par exemple des transistors) et une couche de connexions électriques 310 reliées électriquement aux composants de la couche active 308. Dans l'exemple décrit ici, une couche sacrificielle 304, destinée à protéger la couche diélectrique 306 lors d'un dépôt ultérieur de diamant, est disposée entre la couche massive 302 et la couche diélectrique 306.

Sur la figure 9B, une couche de maintien mécanique 312, par exemple à base de résine ou d'un matériau diélectrique tel que du SiO₂ ou encore à base de semi-conducteur, est solidarisée temporairement à la couche de connexions 310.

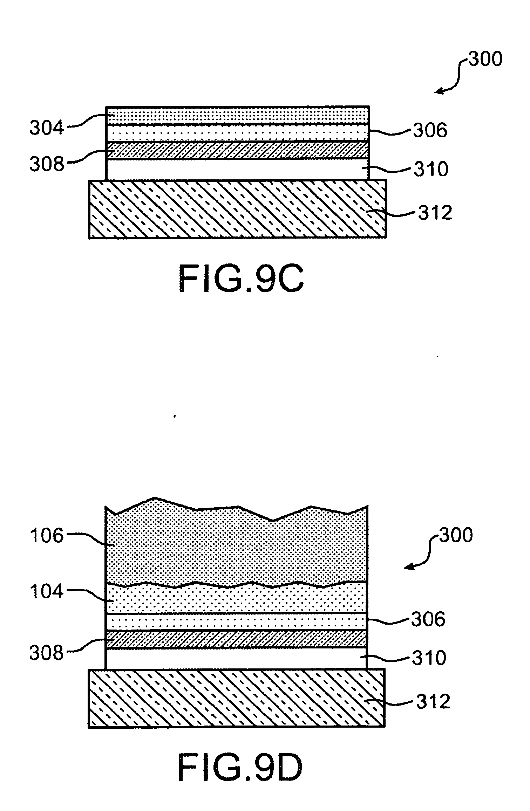

La couche massive 302 est ensuite retirée de la structure, par exemple par polissage, meulage, attaque chimique ou toute autre technique adaptée (figure 9C).

De manière analogue aux modes de réalisation précédemment décrits, on réalise la croissance de la couche de diamant intrinsèque 104 sur la couche diélectrique 306, cette croissance entraînant la suppression de la couche sacrificielle 304, puis la croissance ou le dépôt de la couche de diamant 106 sur la couche de diamant intrinsèque 104 et le dopage de la couche de diamant 106 afin que celle-ci devienne électriquement conductrice (figure 9D). Il est ensuite possible de retirer la couche de maintien mécanique 312 afin de réaliser la mise en boitier du circuit 300.

Dans une variante, la couche de diamant intrinsèque 104 peut être déposée directement sur la couche diélectrique 306 ou sur la couche de silicium 308.

## Revendications

1. Substrat semi-conducteur (100, 200) comportant au moins :
- une couche à base de diamant dopé (106) d'épaisseur supérieure ou égale à environ 10 µm,
- un empilement de couches comprenant une couche à base d'au moins un semi-conducteur (102),
- une couche à base de diamant intrinsèque (104) disposée contre la couche à base de diamant dopé (106), entre la couche à base de diamant dopé (106) et la couche à base de semi-conducteur (102),
l'empilement de couches comportant en outre une couche diélectrique (202) disposée entre la couche à base de semi-conducteur (102) et la couche à base de diamant intrinsèque (104).

2. Substrat (100, 200) selon la revendication 1, la couche à base de diamant intrinsèque (104) ayant une épaisseur comprise entre environ 50 nm et 1 µm et/ou la couche de diamant dopé (106) ayant une épaisseur comprise entre environ 10 µm et 700 µm.

3. Substrat (100, 200) selon l'une des revendications précédentes, comportant en outre une couche de maintien mécanique (108) à base de semi-conducteur et/ou d'un matériau diélectrique et/ou de résine et/ou de métal, la couche à base de diamant dopé (106) étant disposée entre la couche à base de diamant intrinsèque (104) et ladite couche de maintien mécanique (108).

4. Substrat (200) selon l'une des revendications précédentes, la couche diélectrique (202) ayant une épaisseur comprise entre environ 1 nm et 20 nm et/ou étant à base d'au moins un matériau de permittivité inférieure à celle du diamant.

5. Procédé de réalisation d'un substrat semi-conducteur (100, 200), comportant une étape de réalisation d'au moins une couche diélectrique (202) sur une couche à base d'au moins un semi-conducteur (102, 210), formant un empilement de couches, puis au moins les étapes de :
a) dépôt ou croissance d'une couche à base de diamant intrinsèque (104) sur la couche diélectrique (202),
b) dépôt ou croissance d'une seconde couche à base de diamant (106) d'épaisseur supérieure ou égale à environ 10 µm sur la couche à base de diamant intrinsèque (104),
c) dopage de la seconde couche à base de diamant (106).

6. Procédé selon la revendication 5, dans lequel l'étape c) de dopage est mise en oeuvre simultanément à l'étape b) de dépôt ou de croissance.

7. Procédé selon l'une des revendications 5 ou 6, comportant en outre, entre l'étape de réalisation de la couche diélectrique (202) et l'étape a) de dépôt
ou de croissance, une étape de réalisation d'au moins une couche de nucléation (208) à base d'au moins un matériau diélectrique et/ou d'un matériau semi-conducteur et/ou d'un matériau métallique sur ladite couche diélectrique (202), la couche de nucléation (208) étant gravée totalement ou partiellement lors de la mise en oeuvre de l'étape a) de dépôt ou de croissance.

8. Procédé selon l'une des revendications 5 à 7, dans lequel l'empilement de couches comporte une couche d'arrêt de gravure (116, 206) à base d'un matériau diélectrique ou de semi-conducteur dopé disposée contre la couche à base de semi-conducteur (102), la couche d'arrêt de gravure (116, 206) étant disposée contre une seconde couche à base de semi-conducteur (114, 204).

9. Procédé selon la revendication 8, comportant en outre, après l'étape c) de dopage, une étape de retrait de la seconde couche (114, 204) à base de semi-conducteur et/ou de la couche d'arrêt de gravure (116, 206).

10. Procédé selon l'une des revendications 5 à 7, comportant en outre, entre les étapes a) et b) de dépôt ou de croissance, une étape d'implantation ionique dans la couche à base de semi-conducteur (210), formant une interface de fracture (212) dans la couche à base de semi-conducteur (102, 210), et après l'étape c) de dopage, une fracture de la couche à base de semi-conducteur (102, 210) au niveau de l'interface de fracture (212).

11. Procédé selon l'une des revendications 5 à 10, comportant en outre, après l'étape c) de dopage, une étape de solidarisation de la seconde couche à base de diamant dopé (106) à une couche de maintien mécanique (108) à base de semi-conducteur et/ou d'un matériau diélectrique et/ou de résine.

12. Circuit électronique (300) comportant au moins un dispositif semi-conducteur réalisé sur la couche à base de semi-conducteur (308) d'un substrat (100, 200) selon l'une des revendications 1 à 4.

13. Circuit (300) selon la revendication 12, comportant en outre une couche de connexions (310) réalisée sur la couche à base de semi-conducteur (308) et reliée électriquement au dispositif semi-conducteur.

14. Procédé de réalisation d'un circuit électronique (300), comportant au moins les étapes de :
a) réalisation d'une structure comportant au moins d'une couche à base de semi-conducteur (308) dans laquelle est réalisé au moins un dispositif semi-conducteur, disposée sur une seconde couche à base de semi-conducteur (302),
b) solidarisation de la couche à base de semi-conducteur (308) à une couche de maintien mécanique (312) à base de semi-conducteur et/ou d'un matériau diélectrique et/ou de résine,
c) retrait de la seconde couche à base de semi-conducteur (302),
d) mise en oeuvre d'un procédé de réalisation d'un substrat semi-conducteur (100, 200) selon l'une des revendications 5 à 11 à partir de la structure précédemment réalisée.

## Claims

1. Semiconductor substrate (100, 200) comprising at least:
- a layer based on doped diamond (106) with a thickness greater than or equal to approximately 10 µm,
- a stack of layers comprising a layer based on at least one semiconductor (102),
- a layer based on intrinsic diamond (104) disposed against the layer based on doped diamond (106), between the layer based on doped diamond (106) and the semiconductor-based layer (102),
the stack of layers also comprising a dielectric layer (202) disposed between the semiconductor-based layer (102) and the layer based on intrinsic diamond (104).

2. Substrate (100, 200) according to claim 1, the layer based on intrinsic diamond (104) having a thickness of between approximately 50 nm and 1 µm and/or the layer of doped diamond (106) having a thickness of between approximately 10 µm and 700 µm.

3. Substrate (100, 200) according to one of the previous claims, also comprising a mechanical holding layer (108) based on semiconductor and/or a dielectric material and/or resin and/or metal, the layer based on doped diamond (106) being disposed between the layer based on intrinsic diamond (104) and said mechanical holding layer (108).

4. Substrate (200) according to one of the previous claims, the dielectric layer (202) having a thickness of between approximately 1 nm and 20 nm and/or being based on at least one material with a permittivity less than that of diamond.

5. Method of producing a semiconductor substrate (100, 200), comprising a step of producing at least one dielectric layer (202) on a layer based on at least one semiconductor (102, 202), forming a stack of layers, and then at least the steps of:
a) deposition or growth of a layer based on intrinsic diamond (104) on the dielectric layer (202),
b) deposition or growth of a second diamond-based layer (106) with a thickness greater than or equal to approximately 10 µm on the layer based on intrinsic diamond (104),
c) doping of the second diamond-based layer (106).

6. Method according to claim 5, in which the doping step c) is implemented simultaneously with the deposition or growth step b).

7. Method according to one of claims 5 or 6, also comprising, between the step of producing the dielectric layer (202) and the deposition or growth step a), a step of producing at least one nucleation layer (208) based on at least one dielectric material and/or a semiconductor material and/or a metal material on said dielectric layer (202), the nucleation layer (208) being etched completely or partially during the implementation of the deposition or growth step a).

8. Method according to one of claims 5 to 7, in which the stack of layers comprises an etching stop layer (116, 206) based on a dielectric or doped semiconductor material disposed against the semiconductor-based layer (102), the etching stop layer (116, 206) being disposed against a second semiconductor-based layer (114, 204).

9. Method according to claim 8, also comprising, after the doping step c), a step of removing the second semiconductor-based layer (114, 204) and/or the etching stop layer (116, 206).

10. Method according to one of claims 5 to 7, also comprising, between the deposition or growth steps a) and b), a step of ion implantation in the semiconductor-based layer (210), forming a fracture interface (212) in the semiconductor-based layer (102, 210), and after the doping step c), a fracture of the semiconductor-based layer (102, 210) at the fracture interface (212).

11. Method according to one of claims 5 to 10, also comprising, after the doping step c), a step of fixing the second layer based on doped diamond (106) to a mechanical holding layer (108) based on semiconductor and/or a dielectric material and/or resin.

12. Electronic circuit (300) comprising at least one semiconductor device produced on the semiconductor-based layer (308) of a substrate (100, 200) according to one of claims 1 to 4.

13. Circuit (300) according to claim 12, also comprising a connection layer (310) produced on the semiconductor-based layer (308) and electrically connected to the semiconductor device.

14. Method of producing an electronic circuit (300), comprising at least the steps of:
a) producing a structure comprising at least one semiconductor-based layer (308) in which at least one semiconductor device is produced, disposed on a second semiconductor-based layer (302),
b) securing the semiconductor-based layer (308) to a mechanical holding layer (312) based on semiconductor and/or a dielectric material and/or resin,
c) removing the second semiconductor-based layer (302),
d) implementing a method of producing a semiconductor substrate (100, 200) according to one of claims 5 to 11 from the structure previously produced.

## Patentansprüche

1. Halbleitersubstrat (100, 200), welches wenigstens folgendes umfaßt:
- eine Schicht (106) von dotiertem Diamant, mit einer Dicke größer oder gleich 10 µm,
- einen Schichtenstapel, welcher eine Schicht (102) von wenigstens eines Halbleiters umfaßt,
- eine Schicht (104) von intrinsische Diamant, welche gegen die Schicht (106) von dotiertem Diamant anlegen zwischen der Schicht (106) von dotiertem Diamant und der Schicht (102) von eines Halbleiters angeordnet ist,
wobei der Schichtenstapel des weiteren eine Dielektrikumsschicht (202) umfaßt, die zwischen der Schicht auf Halbleiterbasis (102) und der Schicht (104) von intrinsische Diamant angeordnet ist.

2. Substrat (100, 200) nach Anspruch 1, bei welchem die Schicht (104) von intrinsische Diamant eine Dicke im Bereich zwischen etwa 50 nm und 1 µm besitzt und / oder die Schicht (106) von dotiertem Diamant eine Dicke im Bereich zwischen etwa 10 µm und 700 µm besitzt.

3. Substrat (100, 200) nach einem der vorhergehenden Ansprüche, welches des weiteren eine mechanische Trag Schicht (108) von eines Halbleiters und / oder eines dielektrische Materials und / oder eines Harzes und / oder eines Metalls umfaßt, wobei die Schicht (106) von dotiertem Diamant zwischen der Schicht (104) von intrinsische Diamant und der mechanische Trag Schicht (108) angeordnet ist.

4. Substrat (200) nach einem der vorhergehenden Ansprüche, bei welcher die Dielektrikumsschicht (202) eine Dicke im Bereich zwischen etwa 1 nm und 20 nm besitzt und / oder eine Schicht wenigstens eines Materials mit einer niedrigeren Dielektrizitätskonstante als Diamant ist.

5. Verfahren zur Herstellung eines Halbleitersubstrats (100, 200), umfassend eine Verfahrensstufe der Herstellung wenigstens einer Dielektrikumsschicht (202) auf einer Schicht (102, 210) wenigstens eines Halbleiters, unter Bildung eines Schichtenstapels, sodann wenigstens die folgenden verfahrensstufen:
a) Abscheiden oder Aufwachsen einer Schicht (104) von intrinsische Diamant auf der Dielektrikumsschicht (202),
b) Abscheiden oder Aufwachsen einer zweiten Schicht (106) auf Diamantbasis, mit einer Dicke größer oder gleich etwa 10 µm, auf der Schicht (104) von intrinsische Diamant,
c) Dotieren der zweiten Schicht (106) auf Diamantbasis,

6. Verfahren nach Anspruch 5, bei welchem die Stufe c) der Dotierung gleichzeitig mit der Stufe b) des Abscheidens oder Aufwachsens vorgenommen wird.

7. Verfahren nach einem der Ansprüche 5 oder 6, welches des weiteren zwischen der Verfahrensstufe der Herstellung der Dielektrikumsschicht (202) und der Verfahrensstufe a) des Abscheidens bzw. Aufwachsens eine Verfahrensstufe der Herstellung wenigstens eine Kristallisationskeimbildungsschicht (208) umfaßt, wenigstens eines dielektrischen und/oder eines Halbleiter- und/oder eines metallischen Materials, auf der genannten dielektrischen Schicht (202), wobei die Kristallisationskeimbildungsschicht (208) während der Ausführung der Verfahrensstufe a) des Abscheidens oder des Aufwachsens zur Gänze oder partiell geätzt wird.

8. Verfahren nach einem der Ansprüche 5 bis 7, bei welchem der Schichtenstapel eine Ätzstopp-Schicht (116, 206) von eines dielektrischen Materials oder eines dotierten Halbleitermaterials umfaßt, welche in Anlage gegen die Schicht (102) auf Halbleiterbasis angeordnet ist, wobei die Ätzstoppschicht (116, 206) gegen eine zweite Schicht (114, 204) auf Halbleiterbasis angeordnet ist.

9. Verfahren nach Anspruch 8, das des weiteren nach der Verfahrensstufe c) der Dotierung eine Verfahrensstufe der Schrumpfung der zweiten Schicht (114, 204) auf Halbleiterbasis und / oder der Ätzstoppschicht (116, 206) umfaßt.

10. Verfahren nach einem der Ansprüche 5 bis 7, das des weiteren, zwischen den Stufen a) und b) des Abscheidens oder des Aufwachsens, eine Verfahrensstufe der Ionenimplantation in der Schicht (210) auf Halbleiterbasis umfaßt, zur Bildung eines Bruch-interface in der Schicht (102, 210) auf Hableiterbasis, und nach der Dotierungsstufe c) einen Bruch der Schicht (102, 210) auf Halbleiterbasis auf dem Niveau des Bruch-Interface (212).

11. Verfahren nach einem der Ansprüche 5 bis 10, das des weiteren, nach der Dotierungsstufe c), eine Verfahrensstufe der Solidarisation der zweiten Schicht (106) von dotiertem Diamant mit einer mechanischen Halterungsschicht (108) auf Halbleiterbasis und /oder eines dielektrischen Materiales und/oder Harzes umfaßt.

12. Elektronische Schaltung (300), welche wenigstens eine Halbleitervorrichtung umfaßt, die auf der Schicht (308) auf Halbleiterbasis eines Substrats (100, 200) gemäß einem der Ansprüche 1 bis 4 erzeugt wurde.

13. Schaltung (300) nach Anspruch 12, welche des weiteren eine Verbindungsleitungsschicht (310) umfaßt, die auf der Schicht (308) auf Halbleiter-Basis erzeugt und elektrisch mit der Halbleitervorrichtung verbunden ist.

14. Verfahren zur Herstellung einer elektronischen Schaltung (300), das wenigstens die folgenden Verfahrensstufen umfaßt:
a) Erzeugen einer Struktur, welche wenigstens eine Schicht (308) von eines Halbleiters aufweist, in welcher wenigstens eine Halbleitervorrichtung ausgebildet ist, in Anordnung auf einer zweiten Schicht (302) auf Halbleiterbasis,
b) Solidarisation der Schicht (308) auf Halbleiterbasis mit einer mechanischen Halterungsschicht (312) von eines Halbleiters und/oder eines dielektrischen Materials und/oder eines Harzes,
c) Schrumpfen der zweiten Schicht (302) auf Halbleiterbasis,
d) Anwenden eines Verfahrens zur Herstellung eines halbleitersubstrats (100, 200) gemäß einem der Ansprüche 5 bis 11, ausgehend von der zuvor erzeugten Struktur.
